(19) Europäisches Patentamt European Patent Office Office européen des brevets

(11) **EP 1 659 636 B1**

(12) **EUROPEAN PATENT SPECIFICATION**

(45) Date of publication and mention of the grant of the patent:
**04.11.2009 Bulletin 2009/45**

(51) Int Cl.:
***H01L 29/78*** *(2006.01)*     ***H01L 29/49*** *(2006.01)*

(21) Application number: **05025285.7**

(22) Date of filing: **18.11.2005**

(54) **Power MOS semiconductor device**

MOS-Leistungshalbleiteranordnung

Dispositif semi-conducteur MOS de puissance

(84) Designated Contracting States:
**DE FR GB IT**

(30) Priority: **19.11.2004 IT MI20042245**

(43) Date of publication of application:
**24.05.2006 Bulletin 2006/21**

(73) Proprietor: **STMicroelectronics S.r.l.**
**20041 Agrate Brianza (Milano) (IT)**

(72) Inventors:
- **Ferruccio, Frisina**
  **95030 Sant'Agata li Battiati (Catania) (IT)**
- **Ferla, Giuseppe**
  **95021 Acicastello (Catania) (IT)**
- **Magri', Angelo**
  **95032 Belpasso (Catania) (IT)**
- **Grimaldi, Antonio Giuseppe**
  **95037 San Giovanni La Punta (Catania) (IT)**

- **Bazzano, Gaetano**
  **96014 Floridia (Siracusa) (IT)**

(74) Representative: **Ferrari, Barbara**
**Botti & Ferrari S.r.l.,**
**Via Locatelli, 5**
**20124 Milano (IT)**

(56) References cited:
- **SHENAI K ET AL: "SELECTIVELY SILICIDED VERTICAL POWER DOUBLE-DIFFUSED METAL-OXIDE SEMICONDUCTOR FIELD EFFECT TRANSISTORS FOR HIGH-FREQUENCY POWER SWITCHING APPLICATIONS" JOURNAL OF VACUUM SCIENCE AND TECHNOLOGY PART B, vol. 6, no. 6, November 1988 (1988-11), pages 1740-1745, XP000133326 AVS / AIP, MELVILLE, NEW YORK, NY, USA ISSN: 1071-1023**

**Description**

Field of application

The present invention relates to a power electronic device, such as a MOS device of the type comprising a very high integration of elementary MOS transistors and used in multiple applications both at low and high supply voltage.
The invention particularly, relates to a power MOS device and the following description is made with reference to this field of application by way of illustration only.

Prior art

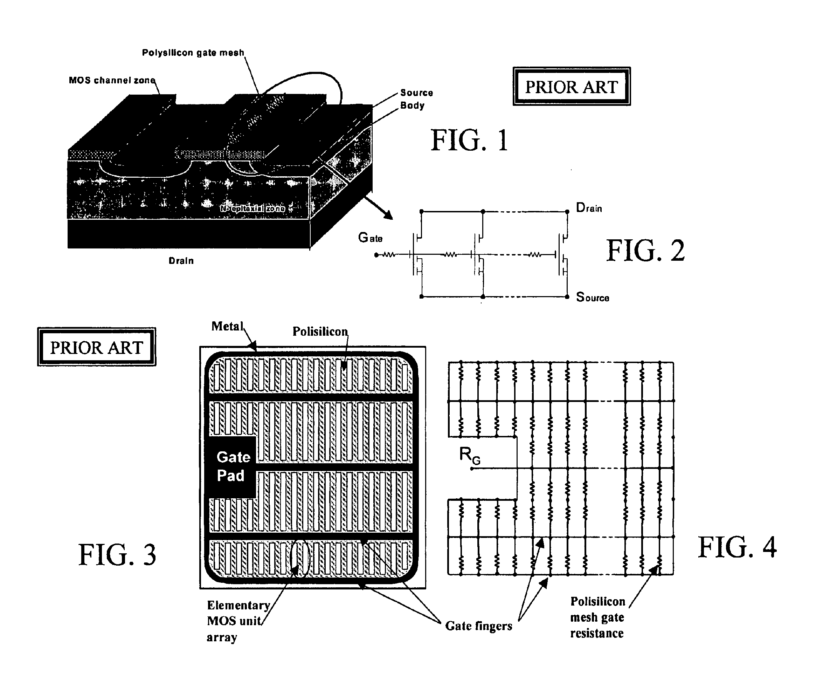

As it is well known, in power electronic devices, in particular in power devices of the MOS type, it is important to have the possibility of operating at higher and higher frequencies maintaining the component reliability high.
The nowadays uses of MOS devices in fact require the possibility of operating, both at low supply voltage (20-100V) and at high supply voltage (200-1000V), but, however, at higher and higher frequencies next to the megahertz (MHz).
Power devices are thus subjected to very high voltage and current gradients during the transients and/or during the switch steps which make the stresses to the device weakening the same burdensome and reduce its activity period in a drastic way.
As it is well known some power MOS devices are realised by thousands or millions of elementary MOS transistors placed in parallel and individually contributing to the overall capacity in current of the device.
Typically, elementary MOS transistors, as highlighted in figure 1, are realised on semiconductor or with polygonal cells or strips and they comprise a body region, which, in the case shown, is of the p type, formed on a suitable substrate, of the n type, and with a source region realised on top.
The body region, together with the source region, forms a channel region covered by an insulating layer, for example a silicon oxide, and by a conductive layer, for example suitably doped polysilicon.
These two insulating and conductive layers represent, for each elementary MOS transistor, the gate dielectric and for the power MOS device they form a biasing mesh also called gate mesh.
The gate mesh is connected to a terminal called gate pad and it allows to distribute the signals inside the MOS device as well as to turn on and/or off all the elementary MOS transistors composing the power MOS device.
The gate mesh, due to the high polysilicon resistivity (> 10 Ohm/square), exhibits resistive contributions along the path which depend on the relative position with respect to the gate pad, as highlighted in the circuit of figure 2, this implies that gate resistance value of each elementary transistor also depends on the distance from the gate pad.
Thus, at each switch of the MOS device, each elementary MOS transistor responds with a time constant which will be distinct, being, as known, a function of the input capacity and of the gate resistance.
The gate resistance is thus an important value because, together with the input capacity of the MOS device, forms an RC circuit whose time constant is one of the most important parameters influencing the switch speed of power MOS devices. These latter, having to operate at higher and higher frequencies, require a more and more reduced time constant. There is then an attempt to reduce the gate resistance and to make it homogeneous for the entire MOS device so as to ensure a good reliability even at high frequency.
To try and solve such problem a known technique is that of carrying out a suitable metallisation of the gate, process consisting in creating connection buses also called gate fingers, realised in metallic material, so as to connect the gate pad to various points of the gate mesh by "short-circuiting" them, as shown in figure 3 and in the corresponding circuit of figure 4.
A technique is that of increasing the number of gate fingers so as to intersect the gate mesh in the greatest number of points as possible.
Although advantageous under several aspects, such solution exhibits different drawbacks, the main one is linked to the presence of the gate fingers realised in metallic material which reduce the active area of the power MOS device since below the same it is not possible to integrate the elementary MOS transistors.
Moreover, a further drawback linked to the presence of the gate fingers is due to the fact that they limit the number and the position of the wires connecting to the source pad thus negatively affecting the output resistance of the power MOS device.
A further known solution to reduce the gate resistance provides the decrease of the gate mesh resistance by integrating there inside a very conductive layer. Such process makes use of metallic silicides, such as for example cobalt silicide ($CoSi_2$), platinum silicide (PtSi), titanium silicide ($TiSi_2$) or tungsten silicide ($WSi_2$), all materials exhibiting a layer resistivity of about a lower magnitude order with respect to that of the polysilicon.
For power MOS devices used in faster and faster applications with low gate resistance, problems however emerge linked to the great voltage and current gradients during the transients.

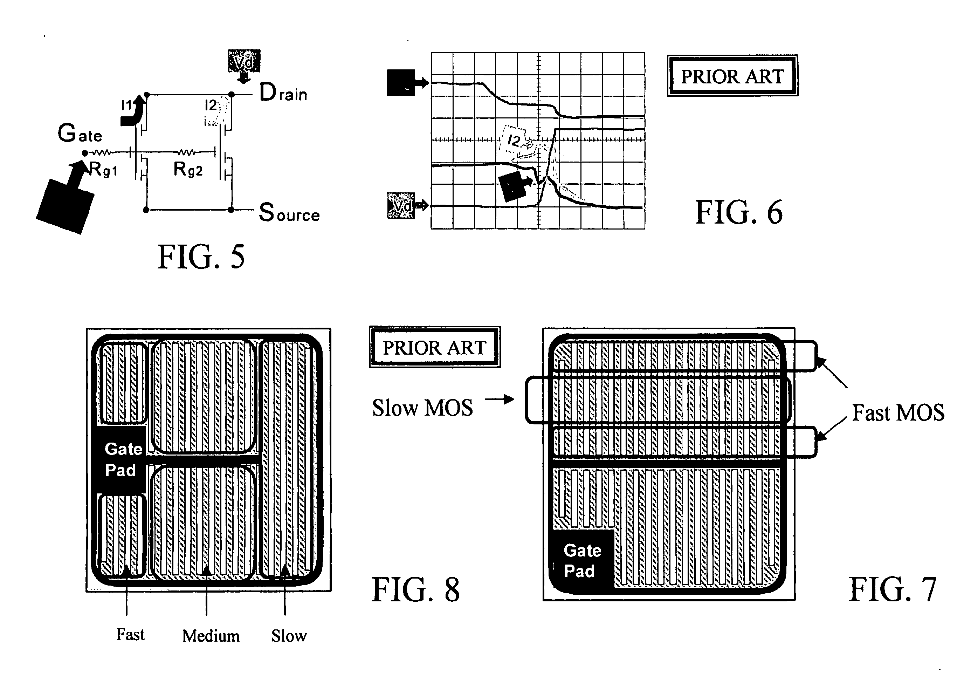

Figure 5 highlights a pattern in parallel of a pair of elementary MOS transistors which exhibit different gate resistances according to the position wherein they are with respect to the gate pad and to the gate fingers.

The diagram reported in figure 6 shows how between elementary MOS transistors wherein there exists an unbalance in the resistance value, during the switch step of the MOS device, different wave forms are produced which distribute the current at stake in a non uniform way. In particular it can be verified how the current intensity 12 crossing the slowest component, undergoes sudden increases negatively affecting the uniformity of the time constant of the MOS device.

Such behaviour in the power MOS device is exponentially increased for the plurality of elementary MOS transistors, this however jeopardises both the correct functionality and the operating duration of the MOS device itself.

For the manufacturing process used in the realisation of a power MOS device of the known type it is inevitable that there are unbalances in the current progress. In fact it is good to remember that the distance between one gate finger and the other is around values of 200-2000 $\mu$m and in such space a lot of elementary MOS transistors are comprised whose gate biasing occurs by means of the gate mesh. In such case the elementary MOS transistors being closer to the gate fingers will be the fastest while the others will be slower and slower, as highlighted in figure 7.

Further unbalances are due to the fact that for problems due to the assembling step it is complex to realise continuous and equidistant gate fingers. Thus, the power MOS device obtained will exhibit areas with different distances between the gate fingers, as shown in the example of figure 8, and this implies the presence of a gate resistance influenced by the area with shortest distance between the gate fingers, since in the calculation of the parallel the areas with higher resistance will have less weight.

Moreover it is good to reveal that although the resistivity of the material used for realising the gate fingers is low, it is possible that their length is such as to introduce resistive contributions which can be compared with the total gate resistance of the power MOS device especially if, for lowering the metallisation mesh resistance, metallic silicides are used.

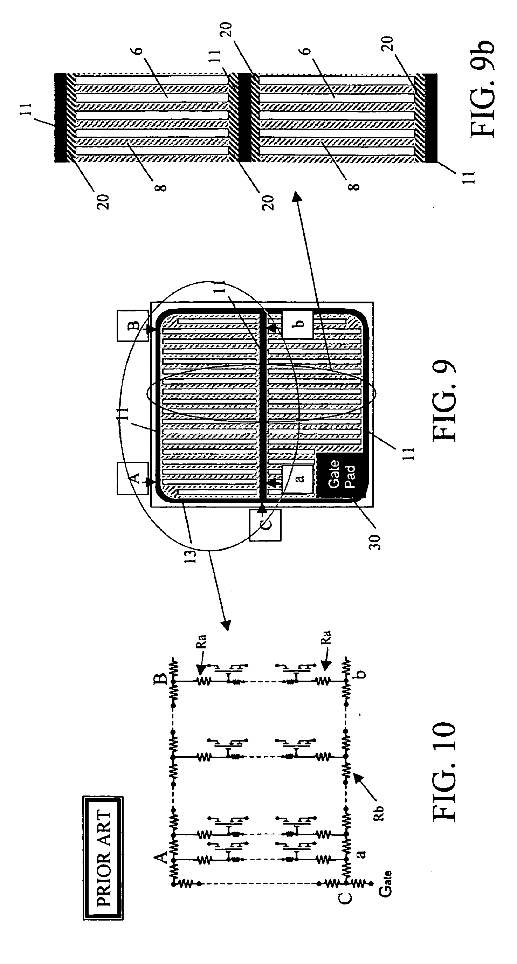

As highlighted in the example of figure 9 and in the associated circuit of figure 10, the areas in correspondence with the points A and B although being near the gate finger exhibit a different resistance in series due to the contribution of the gate finger section AB, which could have an even higher weight than one Ohm, with a consequent unbalance between the different areas of the power MOS device.

Considering for example a width of the metallic tracks of the gate finger equal to 10-50 $\mu$m, a thickness of the metallic layer between 2-10 $\mu$m and fixing at 5mm the width of an aluminium track the values of the minimum resistance of the gate finger will be equal to 0,3 Ohm and the highest equal to 7 Ohm.

It is good to remember that, in a fast power MOS device there is the need of having a total gate resistance equal to 1 Ohm and then the importance is understood of reducing or voiding the resistive contributions of the gate fingers.

All these causes lead to have power MOS devices weakened by the presence of areas having different gate resistance with consequent negative effects on the switches and during the extreme dynamic stresses during which there are high values of dV/dt and/or dI/dt.

The unbalance can also cause current focalisations which can cause the non correct operation and/or the breaking of the power MOS device.

The article included in the Journal of Vacuum Science & Technology B6(1988)Nov./Dec., No.6, New York, US, pages 1740-1745 (Shenai et al.) discloses a power MOSFET structure fabricated with selectively silicided gate and source regions.

The technical problem underlying the present invention is that of devising a power MOS device with a high integration density, comprising a plurality of elementary MOS transistors and with such a gate structure as to ensure a uniform resistance and thus a controlled switch and a simultaneous time constant, exhibiting in the meantime such structural and functional characteristics as to allow to overcome the drawbacks cited with reference to the prior art.

Another aim of the invention is that of uniforming the gate resistance seen from each elementary MOS as much as possible.


Summary of the invention

The solution idea underlying the present invention is that of realising a power MOS device comprising a plurality of elementary MOS transistors and a gate structure realised with a conductive material with programmable resistivity exhibiting a plurality of independent islands, suitably distributed and localised.

On the basis of such solution idea the technical problem is solved by a power MOS device according to claim 1. Specific embodiments are set out in the dependent claims.

The characteristics and the advantages of the power MOS device according to the invention will be apparent from the following description of embodiments given by way of indicative and non limiting example making reference to the annexed drawings.

Brief description of the drawings

- figures 1 and 2 schematically show a section, in an intermediate step of the manufacturing process, of a portion of a power MOS device realised according to the prior art and a corresponding equivalent electric circuit wherein the gate resistance due to the signal distribution by means of the polysilicon mesh (polysilicon gate mesh) is highlighted;

- figure 3 shows, schematically and according to a flat view, the characteristic elements (gate pad, gate fingers, elementary MOS, etc.) of a power MOS device;

- figure 4 shows the equivalent electric scheme of a gate mesh which departs from the gate pad to reach all the elementary MOS;

- figures 5 and 6 show an electric circuit and a diagram reporting the wave forms in voltage and current of a turn off of two elementary MOS transistors of a power MOS device realised according to the prior art;

- figures 7 and 8 show a schematic layout of two different examples of a MOS device according to the prior art;

- figures 9, 9b and 10 schematically show a further example of a power MOS device according to the prior art with the corresponding equivalent circuit;

- figures 11 and 11b show a portion of a power MOS device realised according to the present invention;

- figure 12 shows an equivalent circuit of a portion of a gate structure reported in figure 11;

- figures 13 and 14 show a portion of a further embodiment of a power MOS device according to the present invention;

- figure 15 is a schematic view of an embodiment of the device according to the invention wherein the innovations brought according to the present invention with respect to the known solution of figure 9 are highlighted;

- figures 15a and 15c show an equivalent electric scheme in detail (FIG. 15a) and in blocks (fig. 15c) of a gate mesh of the device reported in figure 15;

- figure 15b shows, only by way of example, how it is possible to realise connection layers with variable resistance according to the present invention;

- figure 16 shows a diagram reporting the progress of a resistance of a gate finger as a function of the length and the progress of a compensation resistance;

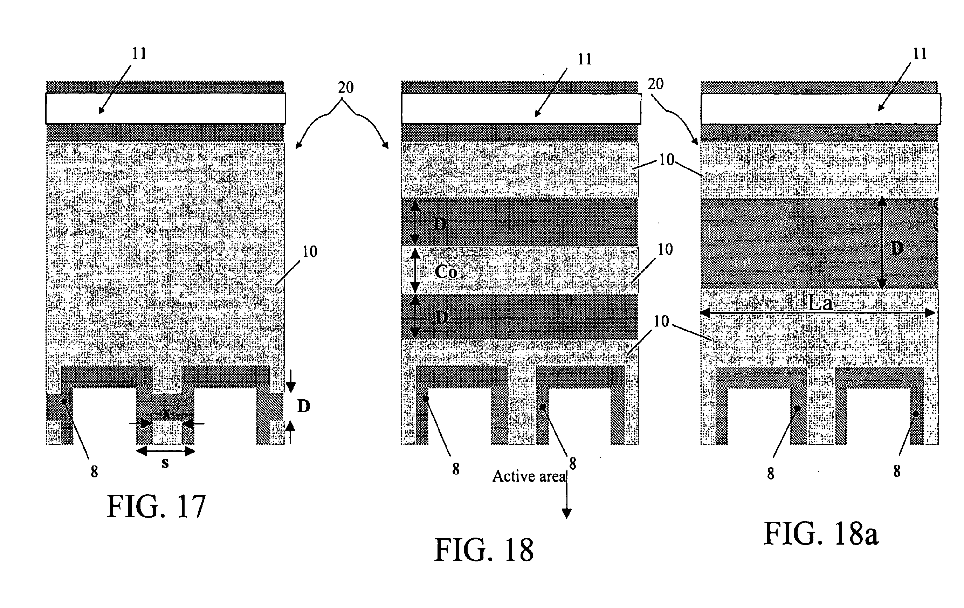

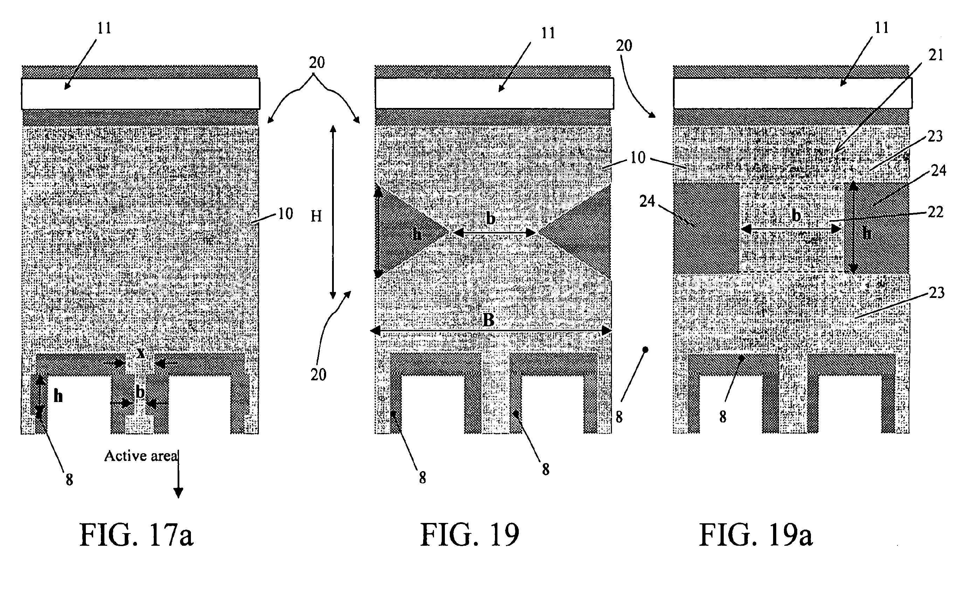

- the series of figures 17 to 19a show some embodiments of a layout portion of a MOS device according to the present invention;

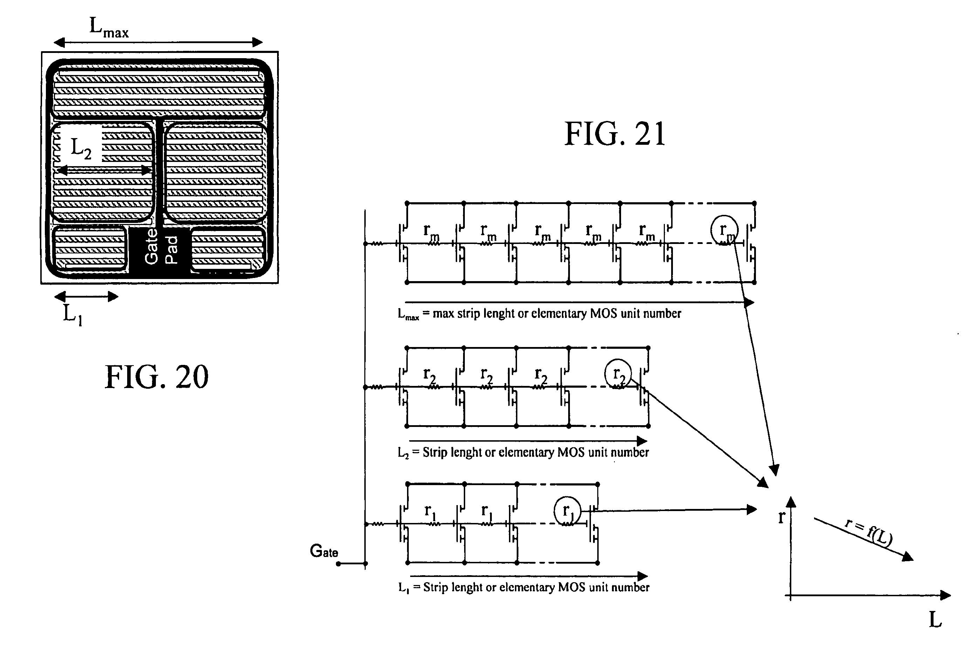

- figure 20 proposes again the MOS device of figure 8 wherein some characteristic lengths have been highlighted;

- figure 21 reports a simplified electric scheme of a series of elementary MOS present in the device of figure 20 wherein the value of the resistance in series on the gate is made change according to what has been said in the present invention.

Detailed description

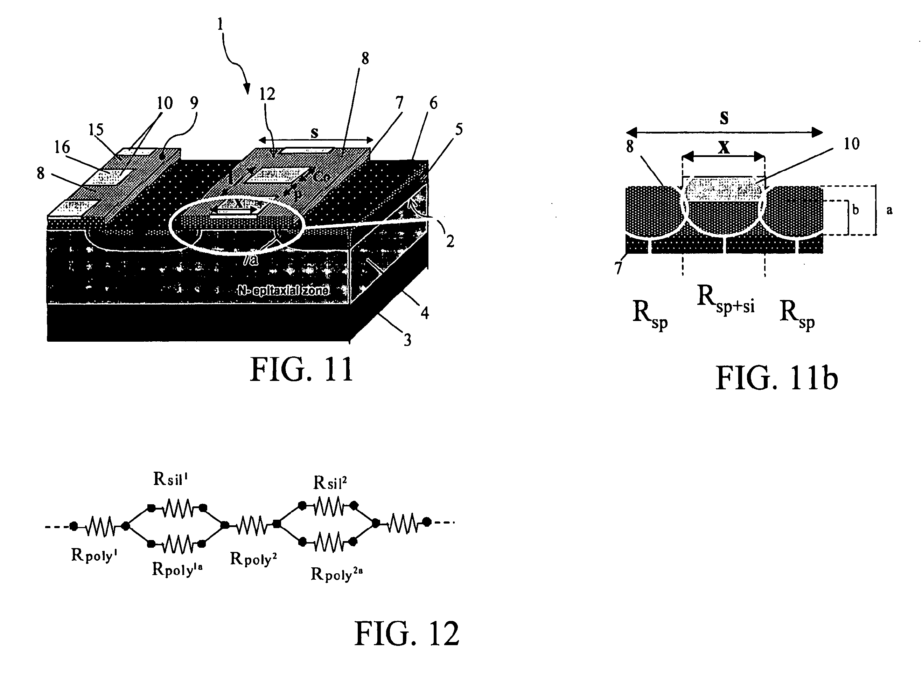

With reference to such figures, and in particular to the embodiment of figure 11, 1 globally and schematically indicates a portion of power MOS device realised according to the present invention.

The device 1 comprises a plurality of elementary MOS transistors 2, arranged in parallel to each other, realised on a silicon plate comprising a semiconductor layer 4 overlapped onto a substrate 3. The layer 4 exhibits a first type of conductivity which, in the case highlighted in the figure, is of the N- type while the substrate 3 is of the N+ type with increased doping.

The elementary MOS transistors 2 shown in the figures are realised only by way of indication with strip-like structures, even if the present invention can be applied on devices with elementary MOS transistors with cellular structure.

The elementary MOS transistors 2 exhibit a body region 5, realised with a second type of conductivity, a source region 6 contained above such body region 5 and an overlying gate oxide 7 which partially covers the body 5 and the source region 6 to define an underlying channel region 7a.

The MOS device 1 exhibits a gate structure 12 comprising a plurality of strips 8 realised with a first conductive material, such as for example polysilicon, arranged above the gate oxide 7 and self-aligned thereto.

The strips 8, according to a standard layout, can be directly connected to a gate pad 30, suitably provided on the upper surface of the MOS device 1, or they can be connected thereto by means of a plurality of gate fingers or metallic tracks 11.

The gate fingers 11, where present, are realised in particularly conductive material, such as a metal, and they thus allow to quickly transfer each signal coming from the gate pad 30 directly to the plurality of conductive strips 8 and thus to the single elementary MOS transistors 2 electrically connected.

In the example reported in figure 9 the gate fingers 11 are three, a central one and two lateral ones and, as well highlighted in the other figure 9B, between the gate fingers 11 and the conductive strips 8 there is a connection layer 20 also preferably realised with a conductive material, such as for example polysilicon. This connection conductive layer 20 introduces a further resistive contribution (Ra) in series to the conductive strips 8 (fig. 10) whose value depends on the number and on the dimensions of the islands 10.

The gate structure 12 has programmable resistivity and it comprises a plurality of islands 10 realised with at least a second conductive material having a different resistivity than that of the first conductive material. The plurality of islands 10 are formed on an upper surface 9 of said conductive strips 8.

Suitably, the plurality of islands 10 is realised for example with a metallic silicide or by means of ionic implantation of doping species. In the most advantageous case these islands can be realised by means of selective silicidation of the polysilicon.

A further realisation could however provide that a group of islands 10, or each island 10 of said plurality, can be realised with a conductive material different from another group or from another island 10.

Each island 10 exhibits, in plan, a polygonal conformation. In the preferred embodiment shown in figure 11 each island 10 has a rectangular conformation.

Preferably, the plurality of islands 10 formed on the upper surface 9 of the strip 8 are aligned along such conductive strip 8 and they exhibit realisation parameters of length Co, of width X and of distance p from the preceding which, although varying, meet some relations as better specified hereafter. The depth of these islands 10 depends on the formation process and it is a fix parameter inside the device.

The plurality of islands 10 formed on the upper surface 9 allow to create resistances of suitable value to be connected in series and/or in parallel to the conductive strips 8 to compensate their resistive values.

Each island 10 formed on the upper surface 9 of the strip 8 projects therefrom, as shown in the section of figure 11b and it leans on a polysilicon layer.

According to different embodiments each island 10 can be completely contained in the polysilicon layer or wrapped by the polysilicon layer of the conductive strip 8 with an upper surface coplanar with the surface 9 of the strip 8 or realised on the surface 9 of the strip 8.

Naturally, the values of such realisation parameters of the islands 10 will have to be compatible with the technology used and the equipments employed. Moreover, the conductive material with which the islands 10 can be realised can vary according to the specific needs, being for example cobalt silicide ($CoSi_2$), platinum silicide ($PtSi$), titanium silicide ($TiSi_2$) or tungsten silicide ($WSi_2$).

As already said, moreover, the islands 10 can be realised also by means of selective ionic implantation of doping species which change the resistivity of the polysilicon layer 8 inside the island 10.

The determinant fact for the invention is that the islands 10 have a different resistivity with respect to the remaining parts 15 of the conductive strip 8.

Thus, the conductive strip 8 with programmable resistivity will have first portions 15 realised in a polysilicon layer alternative with second portions 16 realised by a polysilicon layer and with a silicide layer which defines the island 10.

From the electric point of view the resistance of a conductive strip 8, according to the present invention, has an equivalent circuit reported in figure 12 and it is considered as a series n, where n is the number of islands (10) suitably formed in said conductive strip (8), of polysylicon resistances $R_{poly}^{1,2,..n}$ of the first portions 15 alternated with polysilicon resistances $R_{poly}^{1a,2a,...na}$ in parallel with silicide resistances $R_{sil}^{1,2,...n}$ of the second portions 16.

In particular, with reference to figure 11, the unitary resistance r of a strip element 8 having length 1, realised by a first portion 15 and by a second portion 16 being contiguous, will be given by the formula:

$$\mathbf{r} = \frac{p}{l} r_p + \frac{Co}{l} r_{Co}$$

wherein:

> s is the width of the conductive strip 8 and x is the width of each island 10;
> it results:

$$\left( \frac{R_{sp}}{s-x} \mathbin{/\mkern-5mu/} \frac{R_{spsi}}{x} \right)$$

> rp the unitary resistance associated with the first portion 15 in the section p of the conductive strip 8, i.e. $rp = R_{sp}/s$ where $R_{sp}$ is the layer resistance (sheet resistance) of the first portion 15;

> rco the unitary resistance associated with the second portion 16, section Co of the conductive strip 8, i.e. the parallel between the layer resistance of the polysilicon in the section (s-x) and of silicide+silicon in the section.

As it is well known, the resistance value of each conductive strip 8 influences the time constant of the elementary MOS transistors 2 electrically connected to the strip 8 and in particular the response of the MOS device 1 to each signal coming from the gate pad 30 is influenced.

Advantageously the values of the realisation parameters of the islands 10 will be predefined so that each conductive strip 8 responds to each signal coming from the gate pad 30 with a same time constant.

With a simplified analysis it results that the time constant of a conductive strip 8 of length L is equal to (rL)*(cL) where r and c are respectively unitary resistance and capacity of the strip 8.

Naturally, the unitary capacity c depends on the width s of the conductive strip 8 and on the thickness of the underlying gate oxide 7 and it is thus a constant according to the technologies used, in particular it will be independent from the islands 10 introduced.

Thus, indicating with $L_{max}$ the length of a longer strip 8, schematically shown in the examples of figures 20 and 21, and with L the one of a shorter strip 8 and wishing to uniform the time constant RC a relation between the various parameters is attained.

In such case, wishing to speed up the longest strip 8 the islands 10 formed will realise a continuous strip with maximum width and thus with a unitary resistance which will be equal to: $r = r(L_{max}) = rco$. Thus, imposing the equality between the time constants the following relation is obtained:

$$\frac{p}{l} r_p + \frac{Co}{l} r_{Co} = r(L_{max}) \frac{L_{max}^{2}}{L^2}$$

Such relation links the realisation parameters of the plurality of islands 10 to the ratio between the lengths of the smallest and greatest conductive strips 8.

By using realisation parameter, being variable but meeting the above indicated relation, the time constant of the MOS device 1 can be corrected to ratios meeting the following relation:

$$\frac{L_{max}}{L} \le \sqrt{\frac{r_p}{r_{max}}}$$

In such case according to the geometries typical of the technology used as well as to the resolution of the type of photolitographic equipments used ($L_{max}/L$) values are attained being equal to about 3-5, values which allow to obtain a good definition of the time constant and thus of the response of the power MOS device 1 to the external stresses.

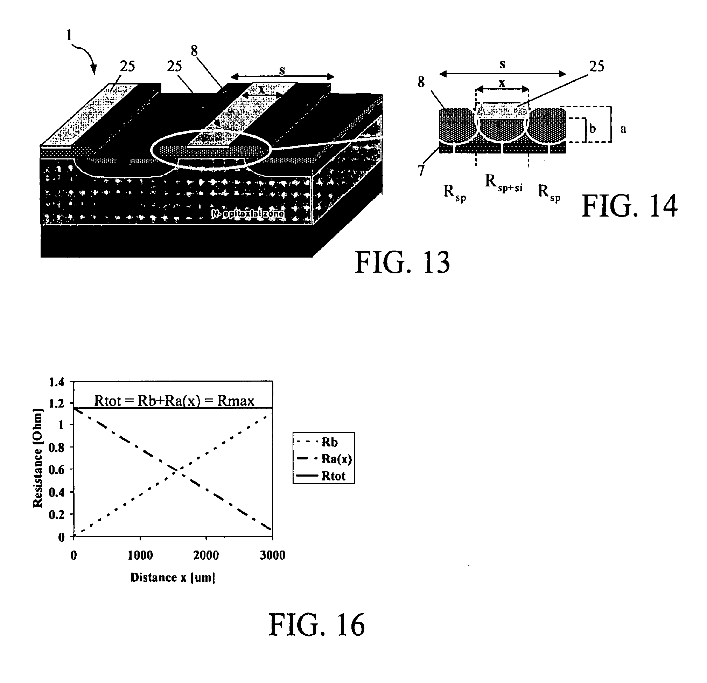

Naturally, as above highlighted, the islands 10 can have correlated realisation parameters and variable arrangements. In particular, according to a second embodiment, as highlighted in figure 13, the islands 10 can be contiguous with at least one attached side, thus forming a continuous strip 25 along the conductive strip 8.

According to such embodiment, the variable dimensional parameter of each island 10 is the width X of the continuous strip 25.

In particular, wishing to uniform all the time constants of the conductive strips 8, which realise the gate structure 12 of the power MOS device 1, and the time constants being, as known, a function of RC, where R is the resistance and C the capacity, it is possible to vary the width of the continuous strip 25, for example by increasing the width X for making the shortest strips 8 become slower.

In the simplified embodiment highlighted in figure 13, the unitary resistance r is given by the parallel between:

the resistance of a polysilicon unitary portion, given by the ratio:

$$\left(\frac{R_{sp}}{s-x}\right)$$

wherein (s-x) is the width of the conductive strip 8 realised in a polysilicon layer of thickness a and $R_{sp}$ is the resistance of such layer, as highlighted in figure 14;
and of the unitary resistance of the conductive strip portion 8 comprising the continuous strip 25 given by the ratio:

$$\left(\frac{R_{spsi}}{x}\right)$$

wherein $R_{spsi}$ is the resistance of the polysilicon layer with reduced thickness b and the overlapped silicide layer, while x is the width of the continuous strip 25.

Carrying out thus the calculation of the parallel the value of the unitary resistance is equal to:

$$r = \frac{R_{sp} \cdot R_{spsi}}{x \cdot R_{sp} + (s-x) \cdot R_{spsi}}$$

wherein $L_{max}$ is the maximum length of the conductive strips 8 and $x_{max}$ is the greatest width of the continuous strip 25 formed therein, this latter value depending on the technologies used, and imposing the equality of the time constants with any strip 8 of parameters: L of length and x of width of the continuous strip 25, the following relation will result:

$$x = \frac{1}{R_{sp} - R_{spsi}} \left\{ \frac{L^2}{L_{max}^2} \cdot \left[ x_{max} \cdot R_{sp} - (s - x_{max}) \cdot R_{spsi} \right] - s \cdot R_{spsi} \right\}$$

wherein

- $R_{sp}$, is a resistance of the strip portion 8 of the polysilicon layer with thickness a, will have values of about 30-45 Ohm/$_\square$,

- $R_{spsi}$ is a resistance of the strip portion 8 realised by the parallel of the polysilicon layer with reduced thickness b and of the overlapped silicide layer of the continuous strip 25, will have values of about 0.5-5 Ohm/$_\square$

- s is the width of the conductive strip 8.

Such solutions allow to solve, or however to attenuate, the unevenness effect of the gate resistance of the single elementary MOS due to the different length of the conductive strips 8 (see the case reported in figure 8).

From the electric point of view, the power MOS device 1 in the case shown in figure 9 exhibits the three gate fingers 11 which, being realised as metallic tracks, add resistances (Rb in fig. 10) in series to the resistances of the conductive strips 8 which can, separately according to their dimensions, introduce, according to prior art, resistance values equal to 0,3-7 Ohm.

Since it is not possible to void such resistive contribution, a second aim of the present invention is that of compensating the effect of this contribution of each gate finger 11 so as to uniform the resistive contribution seen from all the series of elementary MOS (strip 8) connected thereto.

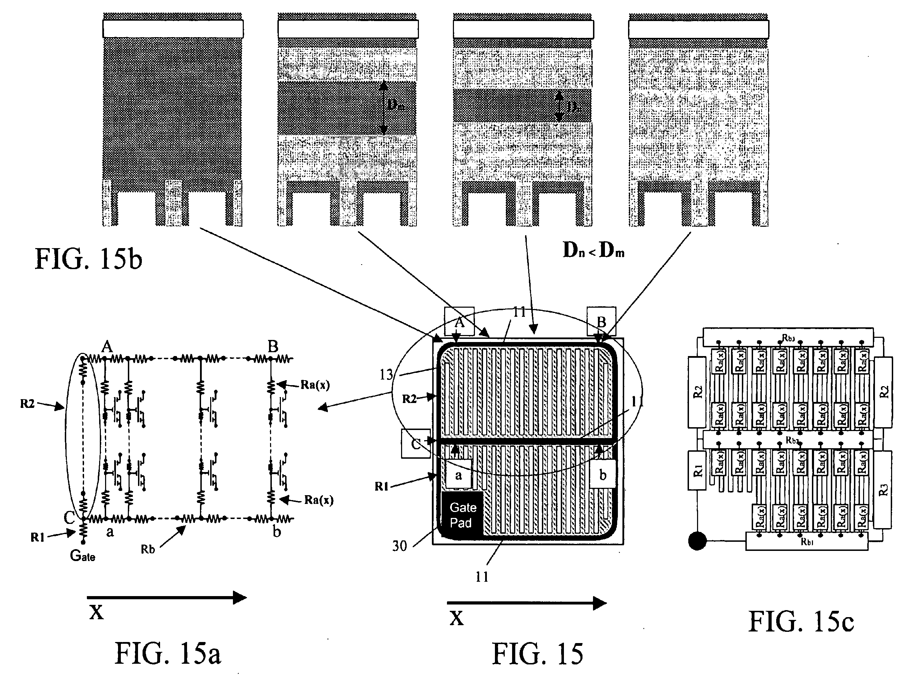

According to the present invention, for reducing the unevenness of the gate resistance generated due to the resistances introduced by the gate fingers 11, between each gate finger 11 and one or more conductive strips 8, resistances (Ra(x)) are realised whose value depends on the distance x from the gate pad or from the start of the gate finger (fig. 15a). Figure 15c reports a block equivalent electric scheme of the device of figure 15 wherein the resistances of the gate fingers (Rb) and the additional ones of the connection layer 20 are highlighted whose value depends on the position.

Such resistances, also called balance resistances and realised in the connection layer 20, allow to compensate the different resistive contribution of the gate fingers 11 according to the distance x from the gate pad 30.

The variable resistances Ra(x) are realised in the connection layer 20 by introducing islands 10 with different resistivity with respect to the remaining conductive area. These islands can have different shapes as shown, only by way of example, in the series of figures 17, 18 and 19.

The determinant characteristic is that one or more geometric parameters can vary according to the distance x influencing, in a known way, the resistive contribution Ra(x).

For example, figure 15 shows a layout of a power MOS device 1 comprising a gate pad 30 connected to two vertical arms 13 with resistance R1 and R2, two external gate fingers 11 and an inner one whose incremental resistances are indicated as $R_b$.

Naturally, the total value of the resistances, $R_b$, depends on the distance x from a reference which can be the gate pad 30 or an edge to which respect the gate pad 30 is realised. In the case shown in figure 15 the reference is the left edge of the plate whereon the power MOS device 1 is realised.

An example of how the structure of the connection layer 20 varies when the distance x varies is reported in figure 15b.

In such representation (fig. 15a) Ra(x) indicates the resistances introduced into the connection layers 20 with the suitable islands 10 formed therein which allow to compensate the different resistance of the gate finger 11 according to the distance x from the left edge of the plate.

Advantageously according to the present invention the value of the resistance Ra(x) is chosen so as to exactly compensate the highest value of the resistive contribution of the gate finger 11, as schematised in the diagram reported in figure 16.

In such way the value of the series between the resistance Ra(x) and the resistance introduced by the gate finger to that position x will have to be constant and equal to the highest resistance. Thus the value of Ra(x), although depending on the distance x from the reference, will be highest for x=0 and minimum for $x=x_{max}$.

Then, for carrying out the compensation of the resistive value of the gate finger Rb it is necessary to single out the farthest point in resistive terms from the gate pad 30, so as to fix the highest resistance value (Rmax) to be compensated.

It is thus possible to calculate $R_a(x)$ imposing that the value of the resistance to be compensated, due to the gate finger 11, both equal to Rmax, i.e. that:

$$R(x=0) + R_b\ x + R_a(x) = Rmax$$

wherein:

R(x=0) is the resistance in series on the branch coming from the gate pad considered for x=0 (for example for the edge R(x=0)= $R_1$ + $R_2$, while for the central gate finger 11 (R(x=0)= $R_1$).

$R_b$ **x** is the product between the unitary resistance of the conductive layer forming the gate finger and the distance x from the reference side and it represents the resistive value introduces by the gate finger to that position.

Thus, making explicit with respect to $R_a(x)$ the relation is obtained:

$$R_a(x) = Rmax - [R(x=0) + R_b\ x]$$

Naturally, the resistance value Ra, equal to the value of resistance Ra(x) which can be calculated with the above indicated formula according to the distance x, must be realised in series to one or to more conductive strips 8 in correspondence with the connection layer 20.

In a preferred embodiment indicated in figure 18a, the resistance Ra can be realised in the connection layer 20 which connects two strips 8 to the gate finger 11, by means of the formation of two independent islands 10, realised transversally to the connection layer 20 and placed at a distance D.

Such connection layer 20, with the two islands 10, exhibits an additional resistance $R_a$ of value equal to:

$$R_a = \frac{D}{L_a}\left(R_{sp} - R_{spsi}\right)$$

wherein:

- $L_a$ is the width of the connection layer 20 and in such case also of the islands 10;

D is the distance between the two islands and $R_{sp}$ the resistance of the connection layer 20 realised only in polysilicon; $R_{spsi}$ is the resistance of the connection layer 20 realised as overlapping between the polysilicon layer and the islands (10) realised with silicide.

According to a further embodiment the value of Ra can be obtained according to the example indicated in figure 19a.

Advantageously, the islands 10 formed on the upper surface of the connection layer 20, are partially connected to each other to form a structure 21 which exhibits a substantially H-like conformation in plan comprising a central portion 22 and two transversal portions 23.

Indicating with

- h the height and b the width of the central portion of the structure 21;

- $L_a$ the width of the connection layer;

- $R_{sp}$ the resistance of the parts of connection layer 20 realised only in polysilicon, which, according to the present embodiment, are two parts 24 lateral to the central portion 21;

- $R_{spsi}$ the resistance of the connection layer 20 with the structure 21 realised with silicide overlapped;

a resistance value Ra or additional one is obtained equal to

$$R_a = h \cdot R_{spsi}\left[\frac{R_{sp}}{bR_{sp} + (L_a - b)R_{spsi}} - \frac{1}{L_a}\right]$$

Thus, advantageously by predefining the values of height h, width b of the structure 21 of islands 10, and $L_a$ width of the connection layer 20 suitable additional resistances $R_a$ of predetermined value can be realised.

The shapes taken by the islands 10 and the cutting or narrowing positions can be obviously different according to the design needs. Figures 17 to 19 show in fact only an example.

The leading idea is that of introducing in the area 20 a resistance whose value varies inside the device so as to compensate the resistive contribution, or better, being dynamic stresses, the impedance introduced by the gate fingers.

These resistances inside the area 20 can be realised by suitably modifying the shape and/or the number of the islands 10 of conductive material.

The power MOS device 1, according to the present invention, thus allows to realise a gate structure 12, comprising conductive strips 8 and possible structures 20 for connection to the gate fingers 11, with variable resistivity according to the islands 10 being formed which allow to suitably modify the gate global resistivity.

The dimensional parameters with which the islands 10 are realised are correlated with the elementary MOS positions inside the device, and the above indicated relations represent only an example.

In particular plural islands 10 will be introduced whose resistances will be in series or in parallel to the resistances of the conductive strips 8 allowing to improve the time constant of each conductive strip 8 and uniforming the response of the power MOS device 1 to each signal coming from the gate pad 30.

An improvement will be thus obtained of the dynamic operation of the power MOS device which will result to be programmable on the basis of the dimensional values of the islands inserted.

A further advantage of the present invention is due to the fact that having the gate structure 12 a regulable resistivity, according to the dimensions and the material of the islands 10 formed, it is important to ensure a uniform resistance to each elementary MOS transistor 2 and this allows to uniform the time constant RC of the power MOS device 1 thus ensuring a controlled switch also at high operation frequencies.

More in particular, the power MOS device realised by means of the present invention, with a gate structure having programmable resistivity allows to improve and to balance the dynamic response to the signals coming from the gate pad.

**Claims**

1. Power MOS device of the type comprising

    - a plurality of elementary power MOS transistors (2) having a body region (5) and a source region (6) above said body region (5); and
    - a gate structure (12) comprising a plurality of strips (8) realised with a first conductive material;

wherein said gate structure (12) comprises a plurality of islands (10) realised with at least one second conductive material having a different resistivity than that of the first conductive material and projecting in said plurality of conductive strips (8), each of said conductive strips (8) comprises n of said islands (10) and exhibits an equivalent electric circuit formed by a series of first resistive elements, associated with said first conductive material with which said strips (8) are formed, and second resistive elements, each formed by a second resistance associated with said first conductive material in correspondence with the islands (10) in parallel with a third resistance associated with said second conductive material with which the islands (10) are realised, said first and second resistive elements being alternated with each other in said series,
and wherein said series of resistances vary from point to point inside the device.

2. Device according to claim 1 wherein said islands (10) exhibit, in plan, a polygonal conformation.

3. Device according to claim 1 wherein said islands (10) exhibit, in plan, a rectangular conformation.

4. Device according to claim 2 wherein said plurality of islands (10) are aligned along said strip (8).

5. Device according to any one of the preceding claims wherein said islands (10) are contiguous with at least one side attached.

6. Device according to claim 4 wherein said islands (10) with said at least one side attached form a continuous strip (25) along said conductive strip (8).

7. Device according to claim 2 wherein each island (10) formed on said upper surface (9) realised with said second conductive material comprises realisation parameters of length Co, of width X and of distance p from the preceding island (10) which allow to create a resistance $R_{si}$ to be connected in series and/or in parallel to resistances $R_{sp}$ created by said conductive strips (8).

8. Device according to claim 1 wherein said conductive strips (8) are realised in polysilicon and have first portions (15) realised with a single polysilicon layer alternated with second portions (16) realised with a polysilicon layer overlapped with said island (10) formed with a silicide layer.

9. Device according to claim 7 wherein said realisation parameters of each island (10) of said plurality of islands (10) are in relation to the values of the lengths of said strips (8).

10. Device according to claim 7 wherein said realisation parameters of each island (10) of said plurality of islands (10) are in relation to the values of the lengths of said conductive strips (8) according to the following relation:

$$\frac{p}{l}r_p + \frac{Co}{l}r_{Co} = r(L_{max})\frac{L_{max}^{\,2}}{L^2}$$

where 1 is said length of said element sum between said length p of said first portion (15) and said length Co of said second portion (16), $r_p$ said unitary resistance of said first portion (15) and $r_{Co}$ said unitary resistance of said second portion (16), L a length of said conductive strips (8) and $L_{max}$ a maximum length of said conductive strips (8).

11. Device according to claim 6 wherein said continuous strips (25) of islands (10) formed along said conductive strips (8) exhibit a dimensional width X in relation to the length L of said strips (8).

12. Device according to claim 6 wherein indicating with $L_{max}$ a maximum length of said strips (8) and $x_{max}$ a maximum width of said continuous strip (25) formed in said maximum strip (8), and L indicating the length of one of said conductive strips (8), a width of a continuous strip (25) formed on said strip (8) of length L meets the following relation:

$$x = \frac{1}{R_{sp} - R_{spsi}}\left\{\frac{L^2}{L_{max}^{\,2}} \cdot \left[x_{max} \cdot R_{sp} - (s - x_{max}) \cdot R_{spsi}\right] - s \cdot R_{spsi}\right\}$$

wherein

$R_{sp}$ is said resistance of said polysilicon portion;
$R_{spsi}$ is said polysilicon resistance comprising said continuous strip (25);
s is a width of said conductive strip (8).

13. Device according to claim 12 wherein said resistance $R_{sp}$ has values comprised between 30 and 45 Ohm/□ and in that said resistance $R_{spsi}$ has values comprised between 0.5 and 5 Ohm/□.

14. Device according to any one of the preceding claims comprising a gate pad (30) and one or more gate fingers (11) suitable to transmit signals from said gate pad (30) to said conductive strips (8) by means of a connection with a connection layer (20) realised with polysilicon wherein said connection layer (20) comprises at least one island (10) realised with a second conductive material.

15. Device according to claim 14 wherein being $R_{max}$ a maximum resistance of said gate fingers (11) and being $R_{a(x)}$ an additional resistance of said connection layer (20) comprising one or more of said islands (10) said additional resistance Ra(x) meets the following relation:

$$R_{a(x)} = R_{max} - (R_{(x=0)} + R_b\, x)$$

wherein:

$R_{(x=0)}$ is a resistance in series to each of said gate fingers (11) according to the distance from said gate pad (30);
$R_b x$ is the resistance introduced by said gate finger (11) to a distance x;

16. Device according to claim 15 wherein said islands (10) realised in said connection layer (20) are two realised transversally and spaced by a distance D and in that said additional resistance Ra(x) is given by:

$$R_a = \frac{D}{L}\left(R_{sp} - R_{spsi}\right)$$

wherein:

- L is a width and H a total length of said connection layer (20)
- D is said distance between said two islands (10);
- $R_{sp}$ is a resistance of said connection layer (20) realised by a layer with only polysilicon;
- $R_{spsi}$ is a resistance of said connection layer (20) realised by said polysilicon layer overlapped with said islands (10).

17. Device according to claim 15 wherein said islands (10) realised in said connection layer (20) are partially connected to each other to form a structure (21) exhibiting a substantially H-like conformation in plan comprising a central portion (22) and two transversal portions (23), and in that said additional resistance $R_a(x)$ is equal to:

$$R_a = h \cdot R_{spsi} \left[ \frac{R_{sp}}{b R_{sp} + (L-b) R_{spsi}} - \frac{1}{L} \right]$$

wherein:

- L is a width of said connection layer (20);
- h and b are the height and width of said central portion (22) of said structure (21) realised in a polysilicon layer and a silicide layer being overlapped exhibiting a resistance equal to $R_{spsi}$;
- $R_{sp}$ is a resistance of said connection layer (20) realised in a single polysilicon layer.

**Patentansprüche**

1. Leistungs-MOS-Vorrichtung des Typs, die Folgendes aufweist:

   - eine Mehrzahl elementarer Leistungs-MOS-Transistoren (2) mit einem Körperbereich (5) und einem Sourcebereich (6) über dem Körperbereich (5); und
   - eine Gate-Struktur (12), die eine Mehrzahl von Streifen (8) aufweist, die mit einem ersten leitfähigen Material realisiert sind;

   wobei die Gate-Struktur (12) eine Mehrzahl von Inseln (10) aufweist, die mit mindestens einem zweiten leitfähigen Material realisiert sind, das einen anderen spezifischen Widerstand als das erste leitfähige Material aufweist, und die in der Mehrzahl der leitfähigen Streifen (8) hervorstehen, wobei jeder der leitfähigen Streifen (8) eine Anzahl von n Inseln (10) aufweist und ein Ersatzschaltbild bildet, das durch eine Reihe von ersten Widerstandselementen, die dem ersten leitfähigen Material zugeordnet sind, mit dem die Streifen (8) gebildet sind, und zweiten Widerstandselementen, von denen jedes durch einen zweiten Widerstand gebildet ist, der dem ersten leitfähigen Material entsprechend den Inseln (10) zugeordnet ist, parallel mit einem dritten Widerstand gebildet ist, der dem zweiten leitfähigen Material zugeordnet ist, mit dem die Inseln (10) realisiert sind, wobei die ersten und zweiten Widerstandselemente in der Reihe einander abwechselnd vorgesehen sind, und wobei die Reihe der Widerstände von Punkt zu Punkt innerhalb der Vorrichtung variiert.

2. Vorrichtung nach Anspruch 1,
   wobei die Inseln (10) in der Draufsicht eine polygonale Gestalt aufweisen.

3. Vorrichtung nach Anspruch 1,
   wobei die Inseln (10) in der Draufsicht eine rechteckige Gestalt aufweisen.

4. Vorrichtung nach Anspruch 2,
   wobei die mehreren Inseln (10) längs des Streifens (8) ausgerichtet sind.

5. Vorrichtung nach einem der vorausgehenden Ansprüche,
   wobei die Inseln (10) zusammenhängend ausgebildet sind und an mindestens einer Seite angebracht sind.

**6.** Vorrichtung nach Anspruch 4,
wobei die Inseln (10) mit der mindestens einen angebrachten Seite einen kontinuierlichen Streifen (25) entlang dem leitfähigen Streifen (8) bilden.

**7.** Vorrichtung nach Anspruch 2,
wobei jede Insel (10), die auf der oberen Oberfläche (9) ausgebildet ist, die mit dem zweiten leitfähigen Material realisiert ist, Ausbildungsparameter der Länge Co, der Breite X und der Distanz p von der vorhergehenden Insel (10) aufweist, die die Erzeugung eines Widerstands $R_{si}$, zur Verbindung in Reihe und/oder parallel mit durch die leitfähigen Streifen (8) erzeugten Widerständen $R_{sp}$ ermöglichen.

**8.** Vorrichtung nach Anspruch 1,
wobei die leitfähigen Streifen (8) in Polysilizium realisiert sind und erste Bereiche (15), die mit einer einzigen Polysiliziumschicht realisiert sind, abwechselnd mit zweiten Bereichen (16) aufweisen, die mit einer Polysiliziumschicht realisiert sind, die in Überlappung mit der mit einer Silizidschicht gebildeten Insel (10) vorgesehen ist.

**9.** Vorrichtung nach Anspruch 7,
wobei die Ausbildungsparameter von jeder Insel (10) der Mehrzahl von Inseln (10) in Beziehung zu den Werten der Längen der leitfähigen Streifen (8) stehen.

**10.** Vorrichtung nach Anspruch 7,
wobei die Ausbildungsparameter von jeder Insel (10) der Mehrzahl von Inseln gemäß der nachfolgenden Gleichung in Beziehung zu den Werten der Längen der leitfähigen Streifen (8) stehen:

$$\frac{p}{l}r_p + \frac{Co}{l}r_{Co} = r(L_{max})\frac{L_{max}^{2}}{L^{2}}$$

dabei bezeichnen I die Länge der Element-Summe zwischen der Länge p des ersten Bereichs (15) und der Länge Co des zweiten Bereichs (16), $r_p$ den Einheitswiderstand des ersten Bereichs (15) und $r_{Co}$ den Einheitswiderstand des zweiten Bereichs (16), L eine Länge der leitfähigen Streifen (8) und $L_{max}$ eine maximale Länge der leitfähigen Streifen (8).

**11.** Vorrichtung nach Anspruch 6,
wobei die kontinuierlichen Streifen (25) der entlang der leitfähigen Steifen (8) ausgebildeten Inseln (10) eine dimensionsmäßige Breite X in Relation zu der Länge L der Streifen (8) aufweisen.

**12.** Vorrichtung nach Anspruch 6,
wobei bei Bezeichnung einer maximalen Länge der Streifen (8) mit $L_{max}$ und Bezeichnung einer maximalen Breite des in dem maximalen Streifen (8) ausgebildeten kontinuierlichen Streifens (25) mit $X_{max}$ sowie bei Bezeichnung der Länge von einem der leitfähigen Streifen (8) mit L eine Breite eines auf dem Streifen (8) mit der Länge L ausgebildeten kontinuierlichen Streifens (25) folgende Beziehung erfüllt:

$$x = \frac{1}{R_{sp} - R_{spsi}}\left\{\frac{L^{2}}{L_{max}^{2}}\cdot\left[x_{max}\cdot R_{sp} - (s - x_{max})\cdot R_{spsi}\right] - s\cdot R_{spsi}\right\}$$

dabei bezeichnen:

$R_{sp}$ den Widerstand des Polysiliziumbereichs;
$R_{spsi}$ den Polysilizium-Widerstand einschließlich des kontinuierlichen Streifens (25);
s eine Breite des leitfähigen Streifens (8).

**13.** Vorrichtung nach Anspruch 12,
wobei der Widerstand $R_{sp}$ Werte aufweist, die zwischen 30 und 45 Ohm/□ liegen, und wobei der Widerstand $R_{spsi}$

Werte aufweist, die zwischen 0,5 und 5 Ohm/$_\square$ liegen.

**14.** Vorrichtung nach einem der vorausgehenden Ansprüche,
aufweisend einen Gate-Anschluss (30) und einen oder mehreren Gate-Finger (11), der bzw. die zum Übertragen von Signalen von dem Gate-Anschluss (30) zu den leitfähigen Steifen (8) mittels einer Verbindung mit einer mit Polysilizium realisierten Verbindungsschicht (20) geeignet sind,
wobei die Verbindungsschicht (20) mindestens eine Insel (10) aufweist, die mit einem zweiten leitfähigen Material realisiert ist.

**15.** Vorrichtung nach Anspruch 14,
wobei bei Bezeichnung eines maximalen Widerstands der Gate-Finger (11) mit $R_{max}$ und bei Bezeichnung eines zusätzlichen Widerstands der Verbindungsschicht (20), die einen oder mehrere der Inseln (10) aufweist, mit $R_{a(x)}$ der zusätzliche Widerstand $R_{a(x)}$ folgende Beziehung erfüllt:

$$R_{a(x)} = R_{max} - (R_{(x=0)} + R_b x)$$

dabei bezeichnen:

$R_{(x=0)}$ einen Widerstand in Reihe zu jedem der Gate-Finger (11) in Abhängigkeit von der Distanz von dem Gate-Anschluss;
$R_b x$ der durch den Gate-Finger (11) eingeführte Widerstand zu einer Distanz x.

**16.** Vorrichtung nach Anspruch 15,
wobei es sich bei den in der Verbindungsschicht (20) realisierten Inseln (10) um zwei transversal realisierte Inseln handelt, die in einem Abstand D voneinander beabstandet sind, und wobei der zusätzliche Widerstand Ra(x) sich wie folgt ergibt:

$$R_a = \frac{D}{L}\left(R_{sp} - R_{spsi}\right)$$

dabei bezeichnen:

- L eine Breite und H eine Gesamtlänge der Verbindungsschicht (20);
- D den Abstand zwischen den beiden Inseln (10);
- $R_{sp}$ einen Widerstand der Verbindungsschicht (20), die durch eine Schicht ausschließlich mit Polysilizium realisiert ist;
- $R_{spsi}$ einen Widerstand der Verbindungsschicht (20), die durch die Polysiliziumschicht in Überlappung mit den Inseln (10) gebildet ist.

**17.** Vorrichtung nach Anspruch 15,
wobei die in der Verbindungsschicht (20) realisierten Inseln (10) partiell miteinander verbunden sind, um eine Struktur (21) zu bilden, die eine im Wesentlichen H-förmige Gestalt in der Draufsicht bildet und einen zentralen Bereich (22) sowie zwei transversale Bereiche (23) aufweist, und wobei der zusätzliche Widerstand $R_a(x)$ gleich ist mit:

$$R_a = h \cdot R_{spsi}\left[\frac{R_{sp}}{bR_{sp} + (L-b)R_{spsi}} - \frac{1}{L}\right]$$

dabei bezeichnen:

- L eine Breite der Verbindungsschicht (20);
- h und b die Höhe und die Breite des zentralen Bereichs (22) der Struktur (21), der in einer Polysiliziumschicht und einer überlappten Silizidschicht realisiert ist und einen Widerstand aufweist, der gleich R_spsi ist;
- R_sp einen Widerstand der Verbindungsschicht (20), die in einer einzigen Polysiliziumschicht realisiert ist.

**Revendications**

1.  Dispositif MOS de puissance du type comprenant :

    - une pluralité de transistors MOS élémentaires de puissance (2) présentant une région de corps (5) et une région de source (6) au-dessus de la région de corps (5) ; et
    - une structure de grille (12) comprenant une pluralité de bandes (8) réalisées avec un premier matériau conducteur ;

    dans lequel la structure de grille (12) comprend une pluralité d'îlots (10) réalisés avec au moins un second matériau conducteur présentant une résistivité différente de celle du premier matériau conducteur et s'étendant sur la pluralité de bandes conductrices (8), chacune des bandes conductrices (8) comprend n îlots (10) et présente un circuit électrique équivalent formé par une série de premiers éléments résistifs, associée au premier matériau conducteur avec lequel les bandes (8) sont formées, et des seconds éléments résistifs, chacun formé par une seconde résistance associée au premier matériau conducteur en correspondance avec les îlots (10), en parallèle avec une troisième résistance associée au second matériau conducteur avec lequel les îlots (10) sont réalisés, les premiers et seconds éléments résistifs étant alternés les uns avec les autres dans les séries, et dans lequel les séries de résistances varient d'un point à l'autre dans le dispositif.

2.  Dispositif selon la revendication 1, dans lequel les îlots (10) présentent, en plan, une forme polygonale.

3.  Dispositif selon la revendication 1, dans lequel les îlots (10) présentent, en plan, une forme rectangulaire..

4.  Dispositif selon la revendication 2, dans lequel la pluralité des îlots (10) est alignée le long des bandes (8).

5.  Dispositif selon l'une quelconque des revendications précédentes, dans lequel les îlots (10) sont contigus et présentent au moins un côté solidaire.

6.  Dispositif selon la revendication 4, dans lequel les îlots (10) présentant au moins un côté solidaire forment une bande continue (25) le long de la bande conductrice (8).

7.  Dispositif selon la revendication 2, dans lequel chaque îlot (10) formé sur la surface supérieure (9) réalisé avec le second matériau conducteur comprend des paramètres de réalisation de longueur Co, de largeur X et de distance p à partir de l'îlot précédent (10) qui permettent de créer une résistance $R_{Si}$ à connecter en série et/ou en parallèle avec des résistances $R_{SP}$ créées par les bandes conductrices (8).

8.  Dispositif selon la revendication 1, dans lequel les bandes conductrices (8) sont réalisées en polysilicone et présentent des premières parties (15) réalisées avec une seule couche de polysilicone en alternance avec des secondes parties (16) réalisées avec une couche de polysilicone superposée à l'îlot (10) formé d'une couche de siliciure.

9.  Dispositif selon la revendication 7, dans lequel les paramètres de réalisation de chaque îlot (10) de la pluralité d'îlots (10) sont en rapport avec les valeurs des longueurs des bandes (8).

10. Dispositif selon la revendication 7, dans lequel les paramètres de réalisation de chaque îlot (10) de la pluralité d'îlots (10) sont en rapport avec les valeurs des longueurs des bandes conductrices (8), conformément à la relation suivante :

$$\frac{p}{l}r_p + \frac{Co}{l}r_{Co} = r(L_{max})\frac{L_{max}^2}{L^2}.$$

dans laquelle 1 est la longueur de la somme d'éléments entre la longueur p de la première partie (15) et la longueur $C_o$ de la seconde partie (16), $r_p$ est la résistance unitaire de la première partie (15) et $r_{co}$ est la résistance unitaire de la seconde partie (16), L est une longueur des bandes conductrices (8) et $L_{max}$ une longueur maximale des bandes conductrices (8).

**11.** Dispositif selon la revendication 6, dans lequel les bandes continues (25) d'îlots (10) formées le long des bandes conductrices (8) présentent une largeur dimensionnelle X en rapport avec la longueur L des bandes (8).

**12.** Dispositif selon la revendication 6, dans lequel, $L_{max}$ indiquant une longueur maximale des bandes (8) et $X_{max}$ une largeur maximale des bandes continues (25) formées dans la bande maximale (8), et L indiquant la longueur de l'une des bandes conductrices (8), une largeur d'une bande continue (25) formée sur la bande (8) de longueur L correspond à la relation suivants :

$$x = \frac{1}{R_{sp} - R_{spsi}} \left\{ \frac{L^2}{L_{max}^2} \cdot \left[x_{max} \cdot R_{sp} - (s - x_{max}) \cdot R_{spsi}\right] - s \cdot R_{spsi} \right\}$$

dans laquelle .

- $R_{SP}$ est la résistance de la partie en polysilicone ;
- $R_{SPSi}$ est la résistance en polysilicone comprenant la bande continue (25) ;
- s est la largeur de la bande conductrice (8).

**13.** Dispositif selon la revendication 12, dans lequel la résistance $R_{SP}$ présente des valeurs comprises entre 30 et 45 Ohm par carré et la résistance $R_{SPSi}$ présente des valeurs comprises entre 0, 5 et 5 Ohm par carré.

**14.** Dispositif selon l'une quelconque des revendications précédentes comprenant une plage de grille (30) et un ou plusieurs doigts de grille (11) adaptés pour transmettre des signaux provenant de la plage de grille (30) vers les bandes conductrices (8) au moyen d'une connexion avec une couche de connexion (20) réalisée en polysilicone, dans lequel la couche de connexion (20) comprend au moins un îlot (10) réalisé avec un second matériau conducteur.

**15.** Dispositif selon la revendication 14, dans lequel, $R_{max}$ étant une résistance maximale des doigts de grille (11) et $R_{a(x)}$ étant une résistance supplémentaire de la couche de connexion (20) comprenant une ou plusieurs îlots (10), la résistance supplémentaire $R_{a(x)}$ correspond à la relation suivante :

$$R_{a(x)} = R_{max} - (R_{(x=0)} + R_b \ x)$$

dans laquelle :

- $R_{(x=0)}$ est une résistance en série avec chacun des doigts de grille (11) en fonction de la distance à partir de la plage de grille (30) ;
- $R_b x$ est la résistance introduite par le doigt de grille (11) à une distance x.

**16.** Dispositif selon la revendication 15, dans lequel les îlots (10) réalisés dans la couche de connexion (20) sont deux et sont agencés transversalement et espacés d'une distance D, et dans lequel la résistance supplémentaire $R_{a(x)}$ est donnée par la relation suivante :

$$R_o = \frac{D}{L}(R_{sp} - R_{spsi})$$

dans laquelle :

- L est une largeur et H est une longueur totale de la couche de connexion (20) ;
- D est la distance entre les deux îlots (10) ;
- $R_{SP}$ est une résistance de la couche de connexion (20) réalisée avec une couche en polysilicone seulement ;
- $R_{SPSi}$ est une résistance de la couche de connexion (20) réalisée avec une couche en polysilicone superposée aux îlots (10).

**17.** Dispositif selon la revendication 15, dans lequel les îlots (10) réalisés dans la couche de connexion (20) sont partiellement connectés les uns aux autres pour former une structure (21) présentant une forme substantiellement en forme de H, en plan, comprenant une partie centrale (22) et deux parties transversales (23), et dans lequel la résistance supplémentaire $R_a(x)$ est égale à :

$$R_a = h \cdot R_{spsi} \left[ \frac{R_{sp}}{b R_{sp} + (L-b) R_{spsi}} - \frac{1}{L} \right]$$

où :

- L est une largeur de la couche de connexion (20) ;
- h et b sont la hauteur et la largeur de la partie centrale (22) de la structure (21) réalisée dans une couche de polysilicone et une couche de siliciure superposées présentant une résistance égale à $R_{SPSi}$ ;
- $R_{SP}$ est une résistance de la couche de connexion (20) réalisée dans une seule couche en polysilicone.

MOS channel zone

Polysilicon gate mesh

Source
Body

FIG. 1

Drain

Gate

Drain

Source

FIG. 2

Metal

Polisilicon

Gate Pad

$R_G$

FIG. 3

FIG. 4

Elementary
MOS unit
array

Gate fingers

Polisilicon
mesh gate
resistance

EP 1 659 636 B1

FIG. 5

PRIOR ART

FIG. 6

FIG. 8

Fast    Medium    Slow

PRIOR ART

Slow MOS →

Fast MOS

Gate Pad

FIG. 7

FIG. 11

FIG. 11b

FIG. 12

EP 1 659 636 B1

FIG. 10

FIG. 9

FIG. 9b

FIG. 13

FIG. 14

FIG. 16

EP 1 659 636 B1

FIG. 15b

$D_n < D_m$

FIG. 15a

FIG. 15

FIG. 15c

EP 1 659 636 B1

FIG. 20

$L_{max}$

$L_2$

Gate Pad

$L_1$

FIG. 21

$r_m$  $r_m$  $r_m$  $r_m$  $r_m$  $r_m$

$L_{max}$ = max strip lenght or elementary MOS unit number

$r_2$  $r_2$  $r_2$  $r_2$

$L_2$ = Strip lenght or elementary MOS unit number

$r_1$  $r_1$  $r_1$

Gate

$L_1$ = Strip lenght or elementary MOS unit number

$r$

$r = f(L)$

$L$

EP 1 659 636 B1

FIG. 17

FIG. 18

FIG. 18a

EP 1 659 636 B1

FIG. 17a  FIG. 19  FIG. 19a

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Shenai.** *Journal of Vacuum Science & Technology,* 1988, (6), 1740-1745